Europäisches Patentamt

European Patent Office

Office européen des brevets

(19)

(11) Publication number: 0 347 148
A2

# EUROPEAN PATENT APPLICATION

(21) Application number: 89305915.4

(22) Date of filing: 12.06.89

(51) Int. Cl.⁴ H01L 29/78

(30) Priority: 15.06.88 JP 147779/88

(43) Date of publication of application:
20.12.89 Bulletin 89/51

(84) Designated Contracting States:
DE FR GB

(71) Applicant: SEIKO INSTRUMENTS INC.
31-1, Kameido 6-chome Koto-ku
Tokyo 136(JP)

(72) Inventor: Ishii, Kazutoshi c/o SEIKO
INSTRUMENTS INC.
31-1 Kameido 6-chome
Koto-ku Tokyo(JP)

(74) Representative: Caro, William Egerton et al
J. MILLER & CO. Lincoln House 296-302 High
Holborn
London WC1V 7JH(GB)

(54) Semi-conductor non-volatile memory.

(57) A semi-conductor non-volatile memory device
comprises a semi-conductor substrate (1), an elec-
trically erasable programmable memory cell and a
peripheral circuit. The memory cell has a gate oxide
film (4) disposed on the substrate, a floating gate
electrode (5) formed on the gate oxide film, and a
control gate electrode (7) formed in the substrate
under the gate oxide film and separated from the
floating gate electrode through the gate oxide film
for controlling the al level of the floating gate electrode to effect writing and erasing of the memory
cell. The peripheral circuit includes a transistor (12,
13, 15) having another gate oxide film (14) disposed
on the substrate and formed concurrently with the
gate oxide film of the memory cell.

FIG. 1

## SEMI-CONDUCTOR NON-VOLATILE MEMORY

The present invention relates to a semi-conductor non-volatile memory of the floating gate type wherein the writing and erasing of data is effected electrically, and to a method of producing such a memory.

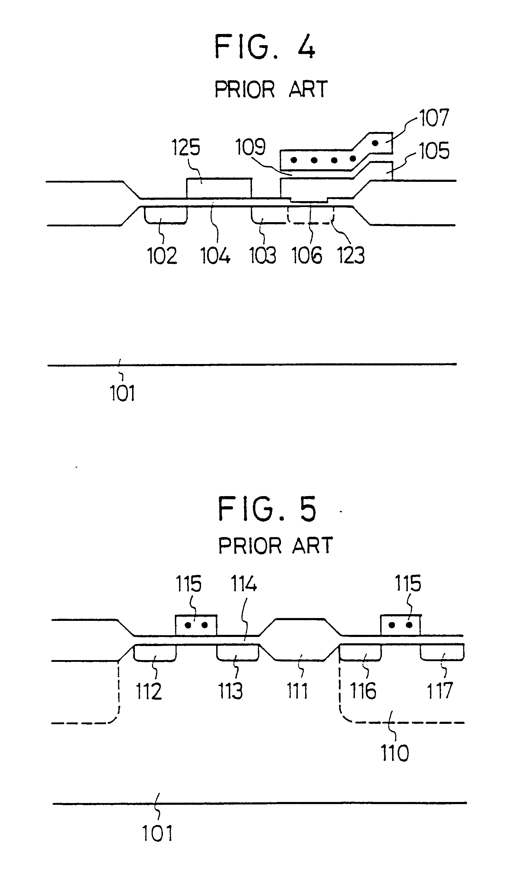

A conventional non-volatile memory wherein the writing and erasing of data is effected electrically (hereinafter referred to as an "EEPROM") is shown in Figures 4 and 5. Figure 4 is a sectional view of a memory cell of the memory and Figure 5 is a sectional view of a peripheral circuit of the memory.

Firstly, the memory cell of Figure 4 will briefly be explained. A source region 102 of N+ type, a drain region 103 of N+ type and a tunnel-drain region 123 of N+ type are concurrently formed in a surface portion of a P type semi-conductor substrate 101. Then, a gate electrode 125 of the memory cell is formed on the substrate 101 above a gate oxide film 104 of the memory cell, and at the same time a floating gate electrode 105 is formed on the substrate through a tunnel oxide film 106. Further, a control gate electrode 107 is formed on the floating gate electrode 105 on a second gate oxide film 109 so as to control the potential level of the floating gate electrode 105. The operations of injecting and extracting electric charge to and from the floating gate electrode 105 are carried out through the tunnel oxide film 106, which is formed on the tunnel-drain region 123.

Next, the peripheral circuit of Figure 5 will briefly be explained. An n-well region 110 and a field oxide film 111 are formed in the P type silicon substrate 101. An N+ type source region 112 and an N+ type drain region 113 are formed in a P type region of the P type silicon substrate 101, and a gate electrode 115 is formed thereon over a gate oxide film 114. A P+ type source region 116 and a P+ type drain region 117 are formed in the n-well region 110, and another gate electrode 115 is formed thereon over the gate oxide film 114. The second gate oxide film 109 of the memory cell is formed concurrently with the gate oxide film 114 of the peripheral circuit.

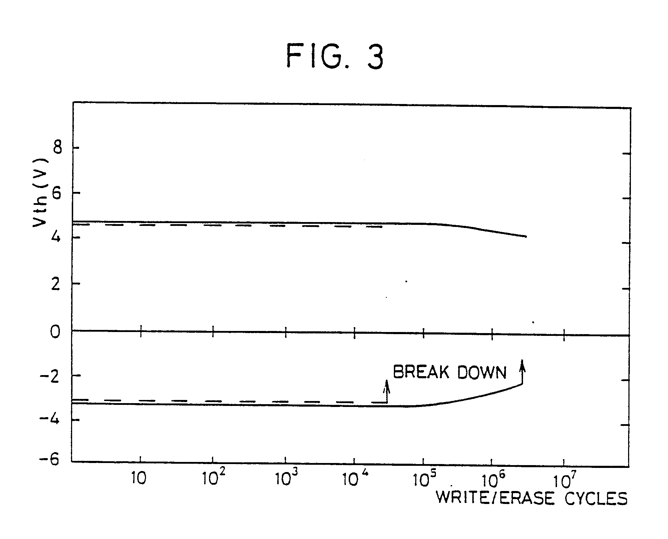

As shown in Figure 4, since the second gate oxide film 109 of the memory cell is formed on the floating gate electrode 105, which is composed of a poly-silicon layer, the second gate oxide film 109 needs to be subjected to heating above the temperature of 1050°C in order to improve its film quality. However, when carrying out the heating process over 1050°C after forming the tunnel oxide film 106 under the floating gate electrode 105, the film quality of the oxide film 106 is degraded, which causes the drawback that the writing facility of the EEPROM is impaired. The possible repetition cycle of a writing operation in the conventional EEPROM is illustrated by dashed lines in Figure 3, in which the abscissa indicates the repetition cycle number of alternate writing and erasing operations and the ordinate indicates threshold voltage $V_{th}$.

According to one aspect of the invention, there is provided a semi-conductor non-volatile memory device comprising a semi-conductor substrate, and an electrically erasable programmable memory cell having a gate oxide film disposed on the substrate, a floating gate electrode formed on the gate oxide film, and a control gate electrode for controlling the potential level of the floating gate electrode to effect writing and erasing of the memory cell, characterised in that the control gate electrode is formed in the substrate under the gate oxide film and is separated from the floating gate electrode through the gate oxide film.

The invention therefore provides a control gate electrode formed within the substrate for controlling the potential level of the floating gate electrode, which eliminates the second gate oxide film provided in the prior art and formed on the floating gate electrode by a high temperature heating process in excess of 1050°C.

By eliminating the formation of the second gate oxide film, the film quality of a tunnel oxide film of the memory cell can be improved and a greater number of writing repetition cycles can be obtained.

According to another aspect of the invention, there is provided a method of forming a semi-conductor non-volatile memory device comprising the steps of forming a gate oxide film on a semi-conductor substrate, forming a floating gate electrode on the gate oxide film, and providing a control gate electrode for controlling the potential level of the floating gate electrode to effect writing and erasing of the memory cell, characterised in that the control gate electrode is formed in the substrate prior to the formation of the gate oxide film on the substrate so as to separate the control gate electrode from the floating gate electrode through the gate oxide film.

The invention is described further, by way of example, with reference to the accompanying drawings, in which:-

Figure 1 is a sectional view through a memory cell of a semi-conductor non-volatile memory according to the present invention;

Figure 2 is a sectional view through a peripheral circuit of the same memory cell;

Figure 3 is a diagram showing writing and erasing repetition characteristics of the semi-conductor non-volatile memory;

Figure 4 is a sectional view through a memory cell of a conventional semi-conductor non-volatile memory;

Figure 5 is a sectional view through a peripheral circuit of the conventional memory;

Figures 6A to 6C show stages in the production of the memory cell of Figure 1; and

Figures 7A to 7C show stages in the production of the peripheral circuit of Figure 2.

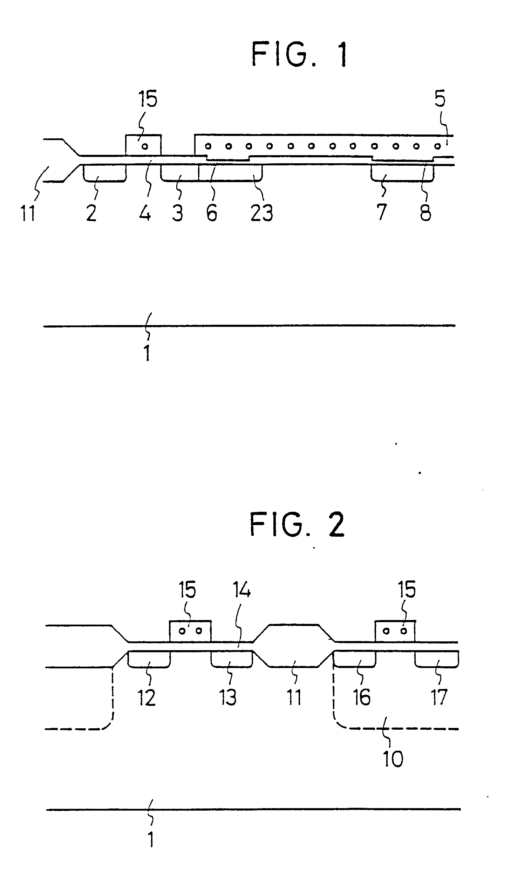

Firstly, the memory cell of Figure 1 will be explained. An N+ type source region 2 and an N+ type drain region 3 including a contiguous tunnel-drain region 23 are formed in a surface portion of a P type silicon substrate 1, and a floating gate electrode 5 is formed thereon over a gate oxide insulating film 4. Operations for injecting and extracting electric charge to and from the floating gate electrode 5 are carried out through a tunnel oxide film 6 formed on the tunnel drain region 23 so as to effect the writing and erasing of bit data. Further, a control gate electrode 7 is formed within the P type silicon substrate 1 under the floating gate electrode 5 through a thin oxide film 8 so as to control the potential level of the floating gate electrode 5. The thin oxide film 8 is formed concurrently with the tunnel oxide film 6.

Next, the peripheral circuit of Figure 2 will be explained. An n-well region 10 and a field oxide film 11 are formed in the surface of the same P type silicon substrate 1. An N+ type source region 12 and an N+ type drain region 13 are formed within the P type surface region of the P type silicon substrate 1, and a gate electrode 15 is disposed thereon over a gate oxide insulating film 14. The gate electrode 15 is formed concurrently with the floating gate electrode 5. A P+ type source region 16 and a P+ type drain region 17 are formed within the n-well region 10, and another corresponding gate electrode 15 is formed thereon above the gate oxide film 14. The gate oxide film 14 of the peripheral circuit is formed concurrently with the gate oxide film 4 of the memory cell. The peripheral circuit comprises complementary MOS transistors effective to drive the memory cell.

Since the control gate electrode 7 is formed within the P type silicon substrate 1 for controlling the potential level of the floating gate electrode 5, a second gate oxide film, which is formed on the floating gate electrode in the prior art structure by heating to a high temperature in excess of 1050° C, can be eliminated, thereby avoiding the degradation of the film dielectric quality of the tunnel oxide film 6 caused in the prior art by the incidental high temperature heating process.

The repetition cycle of alternate writing and erasing operations according to the present invention is illustrated in Figure 3 by solid lines. As can be seen from Figure 3, the reliability or durability of the present EEPROM is greatly improved with respect to writing and erasing as compared with the prior art EEPROM.

In the present EEPROM, a gate oxide film is concurrently formed in both the memory cell and peripheral circuit, and the control gate electrode is formed within the semi-conductor substrate so as to eliminate any high temperature thermal oxidation step after the formation of the floating gate electrode. With such a construction, the film quality of the tunnel oxide film can be improved by comparison with the conventional EEPROM to increase the possible repetition cycle number of alternate writing and erasing operations.

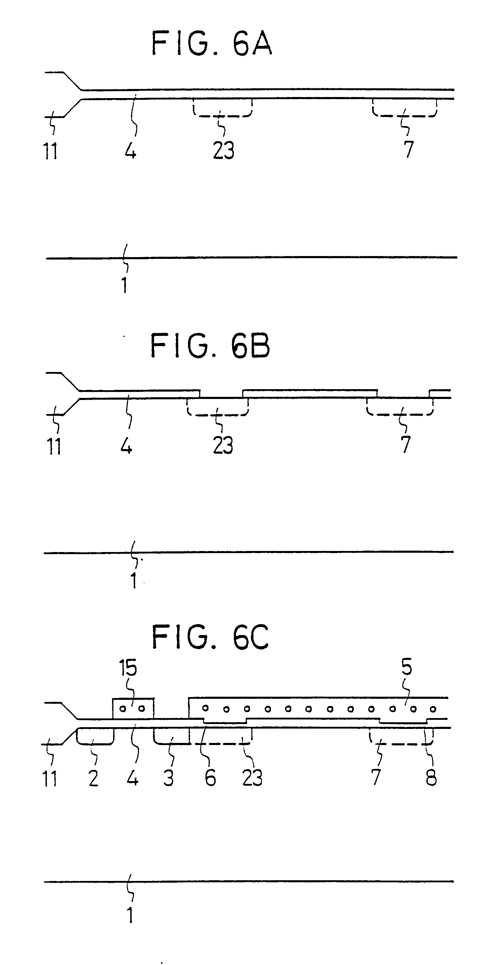

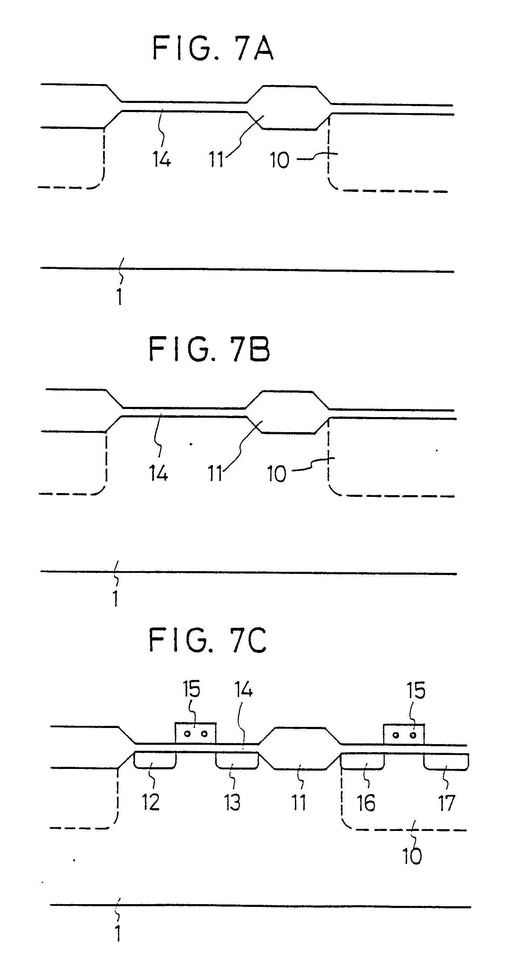

The production of the present EEPROM will now be described with reference to Figures 6A to 6C, which show the production steps for the memory cell, and Figures 7A to 7C, which show the production steps for the peripheral circuit, the memory cell and the peripheral circuit being formed concurrently on the common semi-conductor substrate.

Referring to Figures 6A and 7A, the n-well region 10 and the field oxide film 11 are formed in the P type silicon substrate 1. Then, the gate oxide films 4 and 14 are formed concurrently on the substrate, and thereafter the N+ type tunnel-drain region 23 and the N+ type control gate electrode 7 are formed within the surface region of the substrate under the gate oxide film 4.

Next, referring to Figures 6B and 7B, the gate electrode film 4 is selectively etched to remove a part thereof over the N+ type tunnel-drain region 23 and the N+ type control gate electrode 7.

Lastly, referring to Figures 6C and 7C, the tunnel oxide film 6 and the thin oxide film 8 are concurrently formed on the N+ type tunnel-drain region 23 and the N+ type control gate electrode 7, respectively. Thereafter, the floating gate electrode 5 and an adjacent transistor gate electrode 15 are concurrently formed within the memory cell. Further, the N+ type source regions 2 and 12 and the N+ type drain regions 3 and 13 are formed in the P type surface region of the P type silicon substrate 1, and the P+ type source region 16 and the P+ type drain region 17 are formed within the n-well region 10.

## Claims

1. A semi-conductor non-volatile memory device comprising a semi-conductor substrate (1), and an electrically erasable programmable memory cell having a gate oxide film (4) disposed on the substrate, a floating gate electrode (5) formed on the gate oxide film, and a control gate electrode (7) for controlling the potential level of the floating gate electrode to effect writing and erasing of the memory cell, characterised in that the control gate electrode is formed in the substrate under the gate oxide film and is separated from the floating gate electrode through the gate oxide film.

2. A memory device according to claim 1 characterised by a peripheral circuit including a transistor (12, 13, 15) having a further gate oxide film (14) disposed on the substrate and formed concurrently with the gate oxide film of the memory cell.

3. A memory device according to claim 2 characterised in that the transistor has a transistor gate electrode (15) formed on the further gate oxide film concurrently with the formation of the floating gate electrode on the gate oxide film of the memory cell.

4. A method of forming a semi-conductor non-volatile memory device comprising the steps of forming a gate oxide film (4) on a semi-conductor substrate (1), forming a floating gate electrode (5) on the gate oxide film, and providing a control gate electrode (7) for controlling the potential level of the floating gate electrode to effect writing and erasing of the memory cell, characterised in that the control gate electrode is formed in the substrate prior to the formation of the gate oxide film on the substrate so as to separate the control gate electrode from the floating gate electrode through the gate oxide film.

5. A method according to claim 4 characterised by forming a peripheral circuit including a transistor (12, 13, 15), the transistor including a further gate oxide film (14) formed concurrently with the gate oxide film of the memory cell.

6. A method according to claim 5 characterised by forming a transistor gate electrode (15) of the transistor on the further gate oxide film concurrently with the formation of the floating gate electrode on the gate oxide film of the memory cell.

# FIG. 1

# FIG. 2

# FIG. 3

# FIG. 4
## PRIOR ART

125   109   107
        105

102   104   103   106   123

101

# FIG. 5
## PRIOR ART

115   114        115

112   113   111   116   117

110

101

# FIG. 6A

11    4    23    7

1

# FIG. 6B

11    4    23    7

1

# FIG. 6C

15    5

11    2    4    3    6    23    7    8

1

# FIG. 7A

14  11  10

1

# FIG. 7B

14  11  10

1

# FIG. 7C

15  14  15

12  13  11  16  17

10

1